# EUROPÄISCHE PATENTANMELDUNG

(11) **EP 1 122 603 A1**
(43) Veröffentlichungstag der Anmeldung: **08.08.2001**
(21) Anmeldenummer: 01100265.6
(22) Anmeldetag: 03.01.2001
(51) Int. Cl.: G03F 1/00

(54) **Phasenmaske**

(30) Priorität: 13.01.2000 DE 10001119
(71) Anmelder: Infineon Technologies AG, 81669 München (DE)
(72) Erfinder: Gans, Fritz, 80636 München (DE); Griesinger, Uwe, Dr., 81739 München (DE); Pforr, Rainer, Dr., 01108 Dresden (DE)
(74) Vertreter: Fischer, Volker, Dipl.-Ing.

(57) **Zusammenfassung**

Die Erfindung betrifft eine Phasenmaske (1) zur Belichtung einer photoempfindlichen Schicht bei einem Photolithographieprozess zur Herstellung integrierter Schaltungen mit einem vorgegebenen Muster von lichtdurchlässigen Bereichen. Die Phasenmaske ist in Zonen (3), in welchen die Abstände von benachbarten Bereichen in wenigstens einer Raumrichtung unterhalb eines vorgegebenen Grenzabstands liegen, jeweils als alternierende Phasenmaske ausgebildet. Die Zonen (4) mit isolierten Kontaktfenstern (2) sind jeweils als Halbton-Phasenmaske oder chromlose Phasenmaske ausgebildet.

## Beschreibung

Die Erfindung betrifft eine Phasenmaske gemäß dem Oberbegriff des Anspruchs 1.

Derartige Phasenmasken werden bei Photolithographieprozessen zur Herstellung von integrierten Schaltungen, insbesondere zur Herstellung von Verbindungen von Leitbahnen zur Verdrahtung von integrierten Schaltkreisen eingesetzt.

Diese integrierten Schaltkreise sind in ein Halbleitersubstrat eingearbeitet, welches üblicherweise von einem Silizium-Wafer gebildet ist. Die Leitbahnen werden in Isolatorschichten eingearbeitet, welche unmittelbar oder unter Zwischenlagerung einer Metallschicht auf dem Halbleiter-Substrat aufsitzen. Zur Herstellung der Verbindungen von Leitbahnen in der Isolatorschicht werden in einer Ebene oder in mehreren Ebenen verlaufende Gräben und Kontaktlöcher eingearbeitet, wobei hierzu vorzugsweise Ätzprozesse insbesondere Plasma-Ätzprozesse eingesetzt werden. Um diese Gräben und Kontaktlöcher in die Isolatorschicht einzuarbeiten wird eine Resistmaske mit einem den Gräben und/oder den Kontaktlöchern entsprechenden Lochmuster auf die Isolatorschicht aufgebracht.

Durch die entsprechenden Öffnungen in den Resistmasken werden mit vorgegebenen Tiefen die einzelnen Gräben und Kontaktlöcher eingeätzt. Danach werden die Resistmasken von der Isolatorschicht entfernt. Schließlich wird zur Herstellung der Leitbahnen Metall in die Gräben und/oder Kontaktlöcher abgeschieden.

Die Herstellung von Resistmasken erfolgt mittels bekannter Photolithographieprozesse durch Belichtung einer strahlungsempfindlichen Resistschicht. Durch Aufsetzen von Schablonen oder dergleichen wird diese Resistschicht an vorgegebenen Stellen mit Strahlung, insbesondere Lichtstrahlung beaufschlagt. Danach werden in einem geeigneten Entwickler entweder nur die belichteten oder nur die unbelichteten Bereiche der Resistschicht entfernt.

Bei dem Belichtungsprozess sollen die Strahlen, insbesondere Lichtstrahlen, entsprechend einem vorgegebenen Lochmuster möglichst genau auf die Oberfläche der Resistschicht abgebildet werden. Dabei soll eine möglichst hohe Auflösung erzielt werden, was gleichbedeutend damit ist, einen möglichst abrupten Übergang von belichteten und unbelichteten Stellen in der Photoresistschicht zu erhalten.

Die Belichtung erfolgt dabei derart, dass von einer Strahlungsquelle Strahlung emittiert wird, die über ein Objektiv auf eine Bildebene fokussiert wird, in der sich die Resistschicht befindet. In der Bildebene werden einzelne Substrate mit den darauf aufgebrachten Resistschichten mittels eines Steppers in dem Strahlengang der von der Strahlungsquelle emittierten Strahlen positioniert.

Bei der Belichtung wird die Strahlung durch eine Maske geführt, wobei durch die Struktur der Maske ein bestimmtes Belichtungsmuster vorgebbar ist. Die Maske kann als binäre Maske, beispielsweise in Form einer Chrommaske ausgebildet sein. Derartige Chrommasken weisen eine Anordnung von transparenten Bereichen, die vorzugsweise von einer Glasschicht gebildet sind, und nicht transparenten Schichten auf, die von den Chromschichten gebildet sind.

Zur Erhöhung des Kontrastes von belichteten und nicht belichteten Bereichen auf der Resistschicht wird anstelle einer Chrommaske eine Phasenmaske verwendet. Diese Phasenmasken weisen vorgegebene Muster von lichtdurchlässigen Bereichen in einem opaken Umfeld auf. Zur Strukturierung der Verbindungen von Leitbahnen sind die lichtdurchlässigen Bereiche als Kontaktfenster ausgebildet, deren Abmessungen an die Geometrien der zu erzeugenden Kontaktlöcher angepasst sind.

Eine derartige Phasenmaske kann insbesondere als Halbton-Phasenmaske ausgebildet sein. Bei derartigen Halbton-Phasenmasken sind in vorgegebenen Abständen auf einem Glasträger flächenhaft teildurchlässige Gebiete aufgebracht, deren Schichtdicken so ausgebildet sind, dass die durchgehende Strahlung einen Phasenhub von 180° erfährt.

Weiterhin kann die Phasenmaske auch als alternierende Phasenmaske ausgebildet sein. Eine derartige alternierende Phasenmaske weist jeweils von einer Chromschicht getrennte benachbarte transparente Bereiche auf, die jeweils um 180° verschobene Phasen aufweisen. Das heißt, dass die durch einen transparenten Bereich durchgehende Strahlung um 180° phasenversetzt gegenüber der Strahlung ist, die durch den benachbarten transparenten Bereich geführt ist.

Schließlich kann die Phasenmaske als chromlose Phasenmaske ausgebildet sein. Die chromlose Phasenmaske besteht aus einer Anordnung von lichtdurchlässigen Bereichen, wobei benachbarte Bereiche jeweils einen Phasenunterschied von 180° aufweisen. An den Übergängen zwischen zwei benachbarten Bereichen tritt ein Phasensprung auf. Entlang dieser Phasensprunglinien entstehen bei dem Belichtungsprozess kontrastreiche dunkle Linien.

Zwar kann mit einer dieser Phasenmasken der Kontrast bei der optischen Abbildung gesteigert werden. Nachteilig hierbei ist jedoch, dass die Belichtungsparameter zur Belichtung der Resistschicht sehr genau und in einem engen Bereich vorgegeben werden müssen.

Insbesondere muss die Resistschicht sehr genau im Fokusbereich der Strahlung liegen. Bereits bei geringer Defokussierung werden die Kontrastwerte bei der Belichtung unerwünscht niedrig. Somit wird für den Belichtungsprozess nur ein sehr enges Prozessfenster der optischen Parameter erhalten, innerhalb dessen der Belichtungsprozess zufriedenstellende Ergebnisse liefert. Dies führt zu einem aufwendigen und störungsanfälligen Belichtungsprozess.

Die Durchführung des Belichtungsprozesses ist insbesondere dann erschwert, wenn mit diesem Prozess gleichzeitig sowohl dicht gepackte Strukturen als auch isolierte Strukturen optisch abgebildet werden sollen. Dieses Problem tritt insbesondere bei der Herstellung von Verbindungen von Leitbahnen auf, da dort die entsprechenden Kontaktlöcher sowohl isoliert als auch dicht gepackt angeordnet sein können.

Aus der US 5,446,521 ist eine Halbton-Phasenmaske für einen Photolithographieprozess bekannt, bei welcher lichtdurchlässige Gebiete von teildurchlässigen Gebieten umgeben sind. Zur Belichtung verschiedener Resistschichten werden diese in vorgegebener Reihenfolge mittels eines Steppers in den Strahlengang der von einer Strahlungsquelle emittierten Strahlung gebracht. Das Problem hierbei besteht darin, dass die Positionierung der Resistschichten relativ zu der im Strahlengang befindlichen Halbton-Phasenmaske nicht so exakt durchgeführt werden kann, dass die Resistschichten jeweils einmal belichtet werden. Vielmehr entsteht eine Überlappung bei den einzelnen Positionen, so dass die Strahlung durch die teildurchlässigen Schichten im Randbereich der Halbton-Phasenmaske mehrfach auf die Resistschicht geführt sind, wodurch in diesen Bereichen eine unerwünscht starke Belichtung auftritt. Um diese Belichtung zu reduzieren ist die teildurchlässige Schicht der Halbton-Phasenmaske als opaker Ring ausgebildet, welcher eine Mikrostruktur in Form von Linien aufweist, die durch transparente Mikroschichten getrennt sind. Diese Mikrostruktur ist kleiner als das Auflösungsvermögen des optischen Systems, so dass durch diese Mikrostruktur nahezu keine Belichtung der Photoresistschicht erfolgt. Dabei sind die einzelnen Linien und transparenten Mikroschichten so ausgebildet, dass die Strahlung bei Durchgang durch diese unterschiedlichen Mikroschichten vorzugsweise eine Phasendifferenz von 180° erhält, so dass eine nahezu vollständige Auslöschung der Strahlung auftritt.

In der US 5,680,588 ist ein Beleuchtungssystem zur Belichtung von Resistschichten zur Herstellung von Resistmasken mittels eines Photolithographieprozesses beschrieben. Das Beleuchtungssystem umfasst eine Strahlung emittierende Strahlungsquelle. Die Strahlung ist über eine Phasenmaske, ein Pupillensystem mit mehreren Pixeln und eine Linse auf die Resistschicht geführt. Die Strahlungsquelle wird über eine Kontrolleinheit geregelt. Über einen Bildanalysator werden für unterschiedliche Beleuchtungen die entsprechenden Beleuchtungsmuster analysiert und verglichen. Durch Auswertung dieser Daten wird mittels der Kontrolleinheit die Beleuchtung optimiert.

Der Erfindung liegt die Aufgabe zugrunde, eine Phasenmaske der eingangs genannten Art so auszubilden, dass bei einem Photolithographieprozess eine optimierte Belichtung bei hoher Prozesssicherheit erhalten wird.

Zur Lösung dieser Aufgabe sind die Merkmale des Anspruchs 1 vorgesehen. Vorteilhafte Ausführungsformen und zweckmäßige Weiterbildungen der Erfindungen sind in den Unteransprüchen vorgesehen.

Die erfindungsgemäße Phasenmaske ist in Zonen, in welchen die Abstände von benachbarten lichtdurchlässigen Bereichen in wenigstens einer Raumrichtung unterhalb eines vorgegebenen Grenzabstands liegen, jeweils als alternierende Phasenmaske ausgebildet. In Zonen, in denen die Abstände der benachbarten lichtdurchlässigen Bereiche größer als der Grenzabstand sind, ist die Phasenmaske jeweils als Halbton-Phasenmaske oder chromlose Phasenmaske ausgebildet. Vorzugsweise entspricht der Grenzabstand maximal dem Quotienten λ/NA. Dabei ist λ die Wellenlänge der bei der Belichtung verwendeten Strahlung und NA die numerische Apertur des entsprechenden Abbildungssystems.

Bei der erfindungsgemäßen Phasenmaske sind somit unterschiedliche Zonen vorgesehen, welche verschiedene Typen von Phasenmasken aufweisen. Die Zonen sind dabei an die Abstände zwischen den einzelnen lichtdurchlässigen Bereiche angepasst. Dabei wird der Umstand ausgenutzt, dass für den Fall, dass die lichtdurchlässigen Bereiche dicht benachbart liegen, mit einer alternierende Phasenmaske in einem breiten Bereich der optischen Abbildungsparameter eine gute Abbildungsqualität und damit ein abrupter Übergang von belichteten und nicht belichteten Stellen in der Resistschicht erhalten wird. Derartige dicht gepackte lichtdurchlässige Bereiche können insbesondere von periodischen zweidimensionalen Strukturen, zum Beispiel von Kontaktfenstern zur Erzeugung von Verbindungen von Leibahnen gebildet sein. Desweiteren ergibt sich in Zonen mit lichtdurchlässigen Bereichen, deren Abstände oberhalb des Grenzabstands liegen, durch Verwendung einer Halbton-Phasenmaske oder einer chromlosen Phasenmaske ebenfalls eine gute Abbildungsqualität. Besonders vorteilhaft wird eine Halbton-Phasenmaske dann verwendet, wenn die entsprechende Zone der Phasenmaske lichtdurchlässige Bereiche in einem opaken Umfeld aufweist. Demgegenüber wird vorteilhaft dann eine chromlose Phasenmaske verwendet, wenn in der entsprechende Zone der Phasenmaske schmale, dunkle Bereiche in einem lichtdurchlässigen Umfeld abzubilden sind.

Mit der erfindungsgemäßen Phasenmaske wird sowohl für Bereiche dicht gepackter als auch isolierter lichtdurchlässiger Bereiche in einem breiten Parameterbereich der optischen Komponenten eine gute Abbildungsqualität erhalten. Insbesondere ist die Abbildungsqualität auch in einem relativ großen Bereich unempfindlich gegen eine Defokussierung der Strahlung. Somit wird für die erfindungsgemäße Phasenmaske ein großes Prozessfenster der optischen Parameter des Belichtungssystems erhalten, innerhalb dessen eine nahezu gleichbleibend hohe Abbildungsqualität erzielt wird. Durch diese Optimierung der optischen Parameter wird nicht nur ein stabiler Belichtungsprozess erhalten, vielmehr können damit auch kleine Strukturen sicher auf der Resistschicht abgebildet werden, so dass ein hohes Auflösungsvermögen erzielt wird.

Besonders vorteilhaft wird zur Belichtung der Resistschicht eine hochkohärente Laserlichtquelle, welche vorzugsweise Laserlichtstrahlen in einem Wellenlängenbereich von 150 nm bis 380 nm emittiert, verwendet. Mit einer derartigen Laserlichtquelle wird ein besonders breites Prozessfenster erhalten.

Die Erfindung wird im nachstehenden anhand der Zeichnungen erläutert. Es zeigen:
- Figur 1: Schematische Darstellung eines Ausführungsbeispiels der erfindungsgemäßen Phasenmasken mit verschiedenen, als alternierende Phasenmaske oder Halbton-Phasenmaske ausgebildeten Zonen.
- Figur 2: Schematische Darstellung einer als alternierende Phasenmaske ausgebildeten Zone in der Phasenmaske gemäß Figur 1.
- Figur 3: Schematische Darstellung einer als Halbton-Phasenmaske ausgebildeten Zone in der Phasenmaske gemäß Figur 1.
- Figur 4: Querschnitt durch einen Ausschnitt der Phasenmaske gemäß Figur 1.

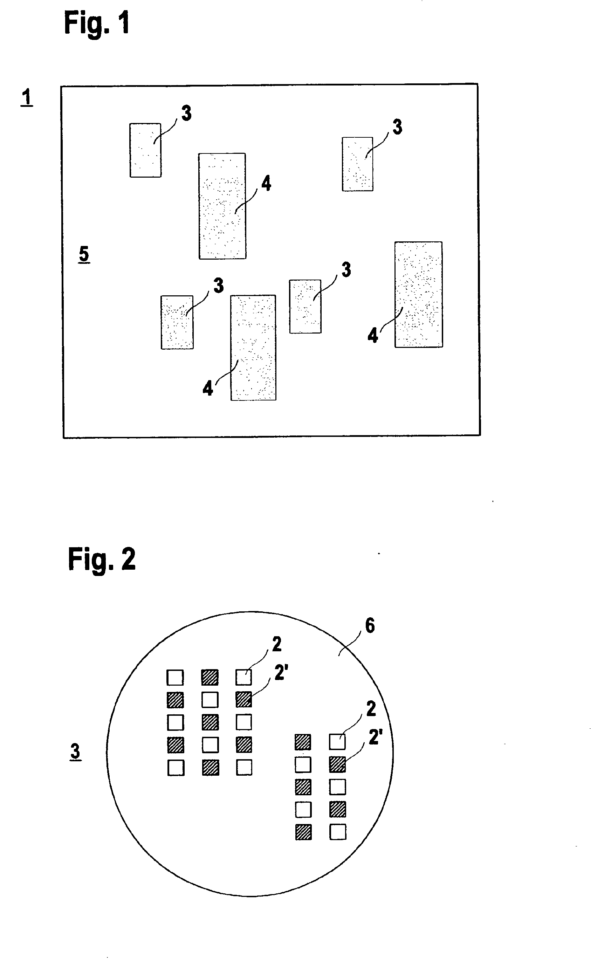

In den Figuren 1 - 4 ist ein Ausführungsbeispiel der erfindungsgemäßen Phasenmaske 1 dargestellt, welche zur Belichtung von photoempfindlichen Schichten bei einem Photolithographieprozess zur Herstellung von integrierten Schaltungen eingesetzt wird.

Derartige Herstellungsprozesse umfassen insbesondere die Herstellung von Kontakten zur Verbindung von Leitbahnen zur Verdrahtung integrierter Schaltungen, die in einem Halbleiter-substrat, insbesondere einem Silizium-Wafer angeordnet sind.

Die Leitbahnen werden in eine Isolatorschicht eingearbeitet, die unmittelbar oder unter Zwischenlagerung einer Metallschicht auf dem Halbleiter-Substrat aufsitzt. Zur Herstellung der Leitbahnen werden nach einem vorgegebenen Muster Gräben und Kontaktlöcher in die Isolatorschicht eingeätzt, in welche anschließend Metall abgeschieden wird.

Das Muster der Gräben und Kontaktlöcher wird durch eine Resistmaske vorgegeben, die auf die Isolatorschicht aufgebracht wird. Die Einarbeitung von Gräben und Kontaktlöchern erfolgt durch ein Ätzen durch die Öffnungen in der Resistmaske.

Die Herstellung der Resistmaske erfolgt mittels eines Photolithographieprozesses. Dabei wird eine die photoempfindliche Schicht bildende Resistschicht an vorgegebenen Schichten belichtet und danach entwickelt. Je nachdem ob es sich bei der Resistschicht um einen Positiv- oder Negativ-Resist handelt, werden bei der Entwicklung die belichteten oder unbelichteten Bereiche der Resistschicht entfernt.

Zur Durchführung des Belichtungsprozesses ist eine Strahlung emittierende Strahlungsquelle vorgesehen. Die Strahlung wird mittels eines Objektivs auf die Resist-Schicht fokussiert. Mittels eines Steppers wird die jeweils zu belichtende Schicht in den Strahlengang der Strahlung in den Brennpunkt des Objektivs verfahren.

Vor dem Objektiv ist die erfindungsgemäße Phasenmaske 1 vorgesehen, welche entsprechend dem auf der Resistschicht zu erzeugenden Lichtmuster lichtdurchlässige Bereiche aufweist. Diese lichtdurchlässigen Bereiche sind entsprechend den Geometrien der zu erzeugenden Kontaktlöcher als Kontaktfenster (2, 2', 2") ausgebildet.

Im vorliegenden Ausführungsbeispiel ist eine von einem Laser gebildete Strahlungsquelle vorgesehen, welche als Strahlung hochkohärente Laserlichtstrahlen emittiert. Die Wellenlängen der Laserlichtstrahlen liegen vorzugsweise in einem Bereich zwischen 150 nm bis 380 nm.

Als Laser wird beispielsweise ein Argon-Fluorid-Laser verwendet, welcher Laserlichtstrahlen bei einer Wellenlänge von 193 nm emittiert. Alternativ können auch schmalbandige Quecksilberdampflampen verwendet werden, die Lichtstrahlen bei einer Wellenlänge von etwa 365 nm emittieren.

Die Phasenmaske 1 gemäß Figur 1 ist in unterschiedliche Zonen 3, 4, 5 aufgeteilt, wobei in ersten Zonen 3, in welchen die Kontaktfenster 2, 2' in wenigstens einer Raumrichtung dichter als im vorgegebenen Grenzabstand liegen, die Phasenmaske 1 jeweils als alternierende Phasenmaske ausgebildet ist. Andererseits ist die Phasenmaske 1 in zweiten Zonen 4, in denen die Abstände benachbarter Kontaktfenster 2" größer als der Grenzabstand sind, jeweils als Halbton-Phasenmaske ausgebildet. Der Maximalwert des Grenzabstands ist durch den Quotienten λ/NA vorgegeben. Dabei ist λ die Wellenlänge der beim Photolithographieprozess verwendeten Strahlung und NA die numerische Apertur des Abbildungssystems.

Die ersten und zweiten Zonen 3, 4 sind jeweils in Abstand zueinander angeordnet und von einer opaken Schicht auf der Phasenmaske 1 voneinander getrennt, welche die dritte Zone 5 bildet. Diese opake Schicht ist vorzugsweise von einer Chromschicht 6 gebildet.

Prinzipiell können in den ersten, als alternierende Phasenmaske ausgebildeten Zonen 3 die lichtdurchlässigen Kontaktfenster 2, 2' dicht gepackt nebeneinander liegen, so dass sowohl in Längsrichtung als auch in Querrichtung der Zone 3 die einzelnen benachbarten Kontaktfenster 2, 2' dichter als der Grenzabstand nebeneinander liegen. Im vorliegenden Ausführungsbeispiel sind in den ersten, als alternierende Phasenmaske ausgebildeten Zonen 3 die Kontaktfenster 2, 2' linear hintereinander angeordnet und bilden Kontaktketten. Ein Beispiel einer derartigen alternierenden Phasenmaske ist in Figur 2 dargestellt. In Längsrichtung einer Kontaktkette sind die benachbarten Kontaktfenster 2, 2' in regelmäßigen Abständen zueinander angeordnet, die unterhalb des Grenzabstands liegen. Die Abstände zwischen zwei nebeneinander verlaufenden Kontaktketten sind jedoch größer als der Grenzabstand.

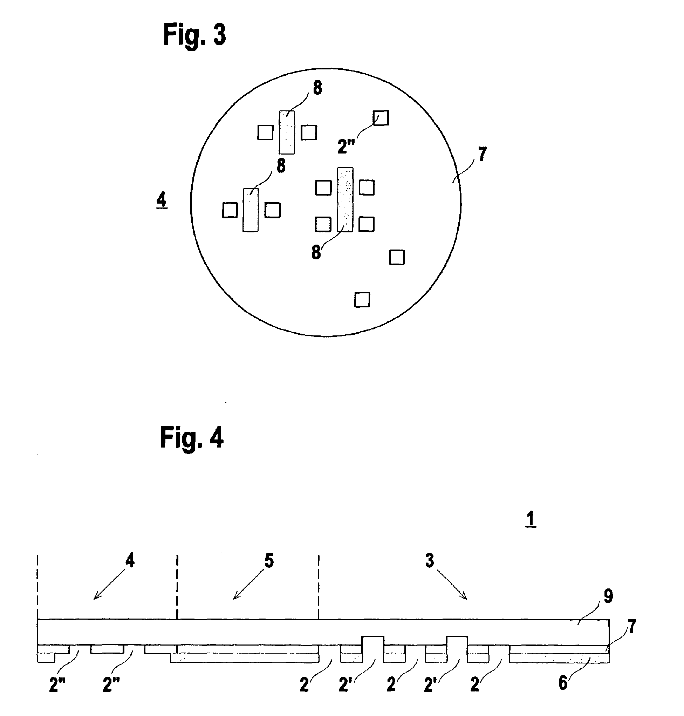

In Figur 3 ist ein Beispiel einer zweiten, als Halbton-Phasenmaske ausgebildeten Zone 4 dargestellt. Diese Zone 4 enthält Kontaktfenster 2", deren Abstände zueinander jeweils beträchtlich größer als der Grenzabstand sind.

Die als Halbton-Phasenmaske ausgebildete Zone 4 gemäß Figur 3 weist eine semitransparente, phasenschiebende Absorberschicht 7 auf. Die isolierten Kontaktfenster 2" sind als Löcher in dieser Absorberschicht 7 ausgebildet. Im vorliegenden Ausführungsbeispiel weisen die Kontaktfenster 2" wiederum einen quadratischen Querschnitt auf. Die semitransparente phasenschiebende Absorberschicht 7 ist vorzugsweise von einer MoSiSchicht gebildet. Die Dicke der Absorberschicht 7 ist so gewählt, dass die während des Belichtungsprozesses auftreffenden Laserlichtstrahlen beim Durchgang durch die Absorberschicht 7 eine Phasendrehung von 180° erhalten.

Wie aus Figur 3 weiter ersichtlich ist, sind an vorgegebenen Stellen der Halbton-Phasenmaske auf die Absorberschicht 7 lokale Chrom-Flächensegmente 8 aufgebracht. Diese Chrom-Flächensegmente 8 bilden Blindfiguren, die zur Unterdrückung von unerwünschten parasitären Strukturen beim Belichtungsprozess dienen. Derartige parasitäre Strukturen beruhen auf Interferenzeffekten der die Kontaktfenster 2" durchsetzenden Lichtstrahlen. Durch die interferierenden Lichtstrahlen entstehen Intensitätsnebenmaxima, die das Belichtungsmuster in der photoempfindlichen Schicht verfälschen.

Die opaken Chrom-Flächensegmente 8 werden jeweils dann zwischen zwei Kontaktfenstern 2" platziert, wenn deren Abstände etwa dem Durchmesser des Beugungsmaximums erster Ordnung des bei der Abbildung erzeugten Luftbildes der entsprechenden Kontaktfenster 2" entsprechen. Die Fläche eines Chrom-Flächensegments 8 hängt von den Parametern des Belichtungssystems ab. Zudem ist die Größe des Chrom-Flächensegments 8 abhängig von der Anordnung und den Abmessungen der anliegenden Kontaktfenster 2". Wie aus Figur 3 ersichtlich sind die Chrom-Flächensegmente 8 stegförmig ausgebildet, wobei die Breite eines Steges etwa der Breite eines Kontaktfensters 2, 2', 2" entspricht. Jeweils zwei dieser Kontaktfenster 2" liegen beidseits eines Chrom-Flächensegments 8 einander gegenüber.

Alternativ zu derartigen Blindfiguren sind auch Sub-Resolutionsstrukturen verwendbar. Derartige Sub-Resolutionsstrukturen werden als feindimensionierte transparente Gebiete ausgebildet, die mit dem Projektionssystem nicht auflösbar sind. Diese Strukturen bewirken eine destruktive Interferenz der durchtretenden Lichtstrahlen mit den Strahlen der Bildstrukturen, so dass keine unerwünschten parasitären Strukturen durch Intensitäts-Nebenmaxima entstehen.

Die in Figur 2 dargestellte, als alternierende Phasenmaske ausgebildete Zone 3 besteht im wesentlichen aus einer opaken Chromschicht 6, in welche die Kontaktfenster 2, 2' als Löcher eingearbeitet sind. Im vorliegenden Beispiel sind die Kontaktfenster 2, 2' jeweils linear hintereinander als Kontaktkette angeordnet. Wie aus Figur 2 ersichtlich, sind dabei zwei Felder von Kontaktfenstern 2, 2' vorgesehen, wobei im ersten Feld drei nebeneinander liegende Kontaktketten und im zweiten Feld zwei nebeneinander liegende Kontaktketten vorgesehen sind. Durch Ätzung eines unter der Chromschicht 6 liegenden transparenten Substrates werden die Kontaktfenster 2' so verändert, dass sich beim Lichtdurchgang im Vergleich zu den Figuren 2 eine Phasendrehung von 180° ergibt. Unter der Chromschicht 6 liegt ein transparentes Substrat.

Auch bei diesen, als alternierende Phasenmasken ausgebildeten Zonen 3 sind die Querschnitte der Kontaktfenster 2, 2' wiederum quadratisch ausgebildet.

Figur 4 zeigt einen Querschnitt durch einen Ausschnitt der Phasenmaske 1 gemäß Figur 1. Dabei ist in Figur 4 sowohl eine als alternierende Phasenmaske ausgebildete Zone 3 als auch eine als Halbton-Phasenmaske ausgebildete Zone 4 dargestellt. Die beiden Zonen 3, 4 sind durch die Chromschicht 6 in einer mittleren Zone 5 voneinander getrennt.

Die erfindungsgemäße Phasenmaske 1 weist eine Glasplatte 9 auf, auf welcher sämtliche Zonen 3, 4, 5, insbesondere die als Halbton-Phasenmaske und alternierende Phasenmaske ausgebildeten Zonen 3, 4 aufgebracht sind. Als Glasplatte 9 werden vorzugsweise Maskenblanks verwendet, die üblicherweise auch zur Herstellung bekannter Phasenmasken verwendet werden.

Zur Herstellung der erfindungsgemäßen Phasenmaske 1 wird zunächst auf die Glasplatte 9 die semitransparente, phasenschiebende Absorberschicht 7 aufgebracht. Anschließend wird auf die Absorberschicht 7 über deren gesamte Fläche eine Chromschicht 6 aufgebracht. In einer besonders vorteilhaften Ausführungsform ist die Chromschicht 6 mit einer nicht dargestellten Chromoxidschicht optisch entspiegelt.

In einem ersten Ätzprozess werden die Kontaktfenster 2, 2', 2" sowohl in der als alternierende Phasenmaske als auch in der als Halbton-Phasenmaske ausgebildeten Zone 3, 4 in die Phasenmaske 1 eingearbeitet, in dem an den hierfür vorgesehenen Orten sowohl die Chromschicht 6 als auch die Absorberschicht 7 entfernt wird. An den Böden der so gebildeten Kontaktfenster 2 liegt dann die Oberfläche der Glasplatte 9 frei.

In einem zweiten Ätzprozess wird in der als alternierende Phasenmaske ausgebildeten Zone 3 jeweils jedes zweite Kontaktfenster 2' einer Kontaktkette weiter ausgeätzt, wodurch ein Teil der Glasschicht im jeweiligen Kontaktfenster 2' entfernt wird. Dabei wird die Glasschicht soweit entfernt, dass die die so gebildeten Kontaktfenster 2' durchsetzenden Laserlichtstrahlen bezüglich der Laserlichtstrahlen, die die benachbarten Kontaktfenster 2 der Kontaktkette, bei welchen die Glasschicht noch vollständig vorhanden ist, eine Phasendifferenz von 180° aufweisen. In Figur 4 sind fünf Kontaktfenster 2, 2' einer solchen Kontaktkette dargestellt, wobei in zwei Kontaktfenstern 2' ein Teil der Glasplatte 9 durch Ätzen entfernt ist. Durch diesen zweiten Ätzprozess ist die als alternierende Phasenmaske ausgebildete Zone 3 fertiggestellt.

Die Fertigstellung der als Halbton-Phasenmaske ausgebildeten Zone 4 erfolgt mittels eines dritten Ätzprozesses, in welchem in der als Halbton-Phasenmaske ausgebildeten Zone 4 mit Ausnahme der Chrom-Flächensegmente 8 die gesamte Chromschicht 6 entfernt wird. Bei dem in Figur 4 dargestellten Fall sind keine Chrom-Flächensegmente 8 dargestellt, so dass in der als Halbton-Phasenmaske ausgebildeten Zone 4 die Chromschicht 6 vollständig entfernt ist. Zwischen den als Halbton-Phasenmaske und alternierende Phasenmaske ausgebildeten Zonen 3, 4 verbleibt die Chromschicht 6 als opake Trennschicht und bildet die dritte Zone 5.

## Patentansprüche

1. Phasenmaske zur Belichtung einer photoempfindlichen Schicht bei einem Photolithographieprozess zur Herstellung integrierter Schaltungen mit einem vorgegebenen Muster von lichtdurchlässigen Bereichen, **dadurch gekennzeichnet**, dass diese in Zonen (3), in welchen die Abstände von benachbarten lichtdurchlässigen Bereichen in wenigstens einer Raumrichtung unterhalb eines vorgegebenen Grenzabstands liegen, jeweils als alternierende Phasenmaske ausgebildet ist, und dass diese in Zonen (4), in welchen die Abstände von benachbarten lichtdurchlässigen Bereichen größer als der Grenzabstand sind, jeweils als Halbton-Phasenmaske oder chromlose Phasenmaske ausgebildet ist.

2. Phasenmaske nach Anspruch 1, **dadurch gekennzeichnet**, dass diese lichtdurchlässige Bereiche in einem opaken Umfeld aufweist, wobei die Phasenmaske in Zonen, in welchen die Abstände von benachbarten lichtdurchlässigen Bereichen unterhalb des Grenzabstands liegen, jeweils als alternierende Phasenmaske ausgebildet ist, und wobei die Phasenmaske in Zonen, in welchen die Abstände von benachbarten lichtdurchlässigen Bereichen größer als der Grenzabstand sind, jeweils als Halbton-Phasenmaske ausgebildet ist.

3. Phasenmaske nach Anspruch 1, **dadurch gekennzeichnet**, dass diese lichtundurchlässige Bereiche in einem lichtdurchlässigen Umfeld aufweist, wobei die Phasenmaske in Zonen, in welchen die Abstände von benachbarten lichtdurchlässigen Bereichen unterhalb des Grenzabstands liegen, jeweils als alternierende Phasenmaske ausgebildet ist, und wobei die Phasenmaske in Zonen, in welchen die Abstände von benachbarten lichtdurchlässigen Bereichen größer als der Grenzabstand sind, jeweils als chromlose Phasenmaske ausgebildet ist.

4. Phasenmaske nach einem der Ansprüche 1 - 3, **dadurch gekennzeichnet**, dass der Grenzabstand maximal dem Quotienten λ/NA entspricht, wobei λ die Wellenlänge der bei dem Photolithographieprozess verwendeten Strahlung und NA die numerische Apertur des Abbildungssystems für die Strahlung ist.

5. Phasenmaske nach einem der Ansprüche 1 - 4, **dadurch gekennzeichnet**, dass deren lichtdurchlässige Bereiche als Kontaktfenster (2, 2', 2") ausgebildet sind.

6. Phasenmaske nach Anspruch 5, **dadurch gekennzeichnet**, dass in den als alternierende Phasenmasken ausgebildeten Zonen (3) die Kontaktfenster (2, 2') in Abständen kleiner als der Grenzabstand als Kontaktketten ausgebildet sind.

7. Phasenmaske nach einem der Ansprüche 1 - 6, **dadurch gekennzeichnet**, dass die als Halbton-Phasenmaske ausgebildeten Zonen (4) eine semitransparente, phasenschiebende Absorberschicht (7) aufweisen.

8. Phasenmaske nach Anspruch 7, **dadurch gekennzeichnet**, dass bei einer während des Photolithographieprozesses durchgeführten Belichtung der Halbton-Phasenmaske Lichtstrahlen beim Durchgang durch die Absorberschicht (7) einen Phasenhub von 180°erhalten.

9. Phasenmaske nach einem der Ansprüche 7 oder 8,
**dadurch gekennzeichnet**, dass die Absorberschicht (7) aus MoSi besteht.

10. Phasenmaske nach einem der Ansprüche 7 - 9,
**dadurch gekennzeichnet**, dass die Kontaktfenster (2") in den als Halbton-Phasenmaske ausgebildeten Zonen (4) von Löchern in der Absorberschicht (7) gebildet sind.

11. Phasenmaske nach einem der Ansprüche 7 - 10 ,
**dadurch gekennzeichnet**, dass auf der Absorberschicht (7) Blindfiguren oder Sub-Resolutionsstrukturen zwischen wenigstens zwei Kontaktfenstern (2") aufgebracht sind, wobei der Abstand zwischen diesen Kontaktfenstern (2") dem Durchmesser des Beugungsmaximums erster Ordnung des bei der Abbildung der Kontaktfenster (2") entstehenden Luftbildes entspricht.

12. Phasenmaske nach Anspruch 11, **dadurch gekennzeichnet**, dass die Blindfiguren von Chrom-Flächensegmenten (8) gebildet sind

13. Phasenmaske nach einem der Ansprüche 7 - 12,
**dadurch gekennzeichnet**, dass die Absorberschicht (7) auf eine Glasplatte (9) aufgebracht ist.

14. Phasenmaske nach einem der Ansprüche 1 - 13,
**dadurch gekennzeichnet**, dass die als alternierende Phasenmaske ausgebildeten Zonen (3) opake Gebiete aufweisen, die jeweils von einer Chromschicht (6) gebildet sind.

15. Phasenmaske nach Anspruch 14, **dadurch gekennzeichnet**, dass die die opaken Gebiete bildenden Chromschichten (6) auf die Absorberschicht (7) aufgebracht sind.

16. Phasenmaske nach Anspruch 15, **dadurch gekennzeichnet**, dass die Chromschichten (6) mit einer Chromoxidschicht optisch entspiegelt sind.

17. Phasenmaske nach einem der Ansprüche 14 - 16,
**dadurch gekennzeichnet**, dass in den die Kontaktfenster (2, 2', 2") bildenden Bereichen zwischen den Chromschichten (6) die Absorberschicht (7) entfernt ist.

18. Phasenmaske nach einem der Ansprüche 14 - 17,
**dadurch gekennzeichnet**, dass in den als alternierende Phasenmasken ausgebildeten Zonen (3) zur Erzeugung einer Phasendifferenz von 180° bei Durchgang der Lichtstrahlen durch benachbarte Kontaktfenster (2, 2') bei einem der Kontaktfenster (2) die Glasplatte (9) ungeätzt und bei dem hierzu benachbarten Kontaktfenster (2') die Glasplatte (9) angeätzt ist.

19. Phasenmaske nach einem der Ansprüche 1 - 18,
**dadurch gekennzeichnet**, dass diese mit hochkohärenten Lichtstrahlen beaufschlagt ist.

20. Phasenmaske nach einem der Ansprüche 1 - 19,
**dadurch gekennzeichnet**, dass diese mit Laserlichtstrahlen im Wellenlängenbereich von 150 nm - 380 nm beaufschlagt ist.
